(19) Europäisches Patentamt
European Patent Office
Office européen des brevets

(11) **EP 1 865 598 A2**

(12) **EUROPEAN PATENT APPLICATION**

(43) Date of publication:
**12.12.2007 Bulletin 2007/50**

(51) Int Cl.:
*H03G 3/30* (2006.01)     *H03G 7/00* (2006.01)
*H03G 11/00* (2006.01)

(21) Application number: **07104520.7**

(22) Date of filing: **20.03.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **07.06.2006 KR 20060051032**

(71) Applicant: **SAMSUNG ELECTRONICS CO., LTD.**
**Suwon-si,**
**Gyeonggi-do (KR)**

(72) Inventors:
• **KIM, Sung-woo**
**Anyang-si**
**Gyeonggi-do (KR)**

• **KIM, Yun-yong**
**Gwonseon-gu**
**Suwon-si**
**Gyeonggi-do (KR)**
• **KIM, Nam-in**
**1003-2102, Bangjuk-maeul**
**Yeongtong-gu**
**Suwon-si**
**Gyeonggi-do (KR)**

(74) Representative: **Benson, Christopher**
**Appleyard Lees**
**15 Clare Road**
**Halifax HX1 2HY (GB)**

(54) **Input-gain control apparatus and method**

(57)     Provided are input-gain control apparatus and method of an audio amplifier. A gain of an acoustic signal is automatically attenuated based on a pre-set limited level to minimize distortion of the acoustic signal caused by clipping of the acoustic signal, and thereby limit an over-input of the acoustic signal to input the acoustic signal within a dynamic range if the acoustic signal is not input within the dynamic range in an audio apparatus including an acoustic amplifier and a switching amplifier. Thus, only a gain of an over-input signal on a specific level or more can be attenuated while an original form of the over-input signal is maintained to minimize distortion of an output waveform caused by clipping of the output waveform. Also, a harmonic distortion and a stepped high frequency noise occurring during clipping can be simultaneously removed.

FIG. 5

**EP 1 865 598 A2**

**Description**

The present invention relates to an input-gain control apparatus and a method of an audio amplifier.

In general, an analog-to-digital (A to D) D-class amplifier circuit performs pulse width modulation (PWM) on an acoustic signal to transform the acoustic signal into a type of digital signal, amplifies the digital signal, and passes the amplified digital signal through a low pass filter (LPF) to recover an original analog signal.

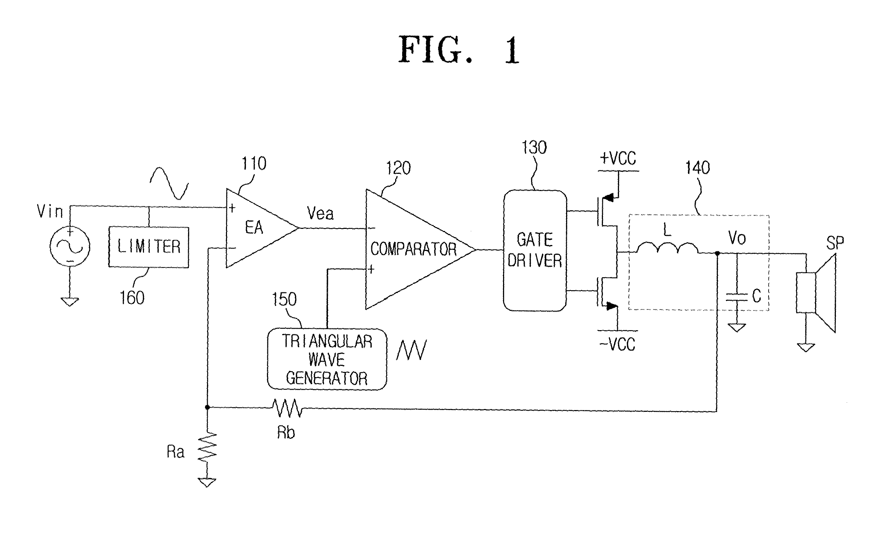

Figure 1 is a schematic diagram illustrating a structure of a related art D-class amplifier circuit. Referring to Figure 1, the conventional D-class amplifier circuit includes an amplifier 110, a comparator 120, a gate driver 130, a low pass filter (LPF) 140, a triangular wave generator 150, and a limiter 160.

As shown in Figure 1, the amplifier 110 is realized in the form of an integrator and compares an input signal with an output signal to generate a signal Vea.

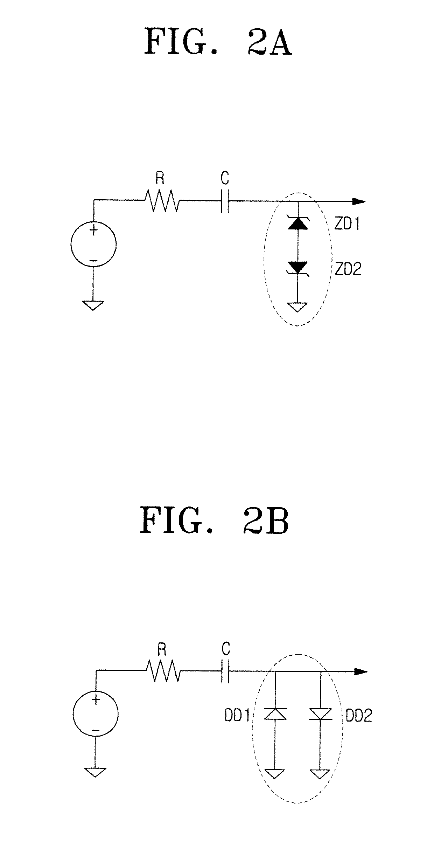

The comparator 120 compares the signal Vea with a triangular wave signal to generate a PWM signal. The gate driver 130 amplifies the PWM signal to drive a metal-oxide-semiconductor field-effect transistor (MOSFET) switch. A signal output from the MOSFET switch, which performs a switching operation according to a gate signal, is low pass filtered by the LPF 140 and applied as an acoustic signal to a speaker SP. Here, the limiter 160 may be constituted at an input port to improve a high frequency distortion component generated when an output signal Vo of the conventional D-class amplifier circuit is clipped by a power source. A general limiter may include general zener diodes ZD1 and ZD2 or general small signal diodes DD1 and DD2 as shown in Figures 2A and 2B.

If an audio signal Vin is input to the conventional D-class amplifier circuit, the amplifier 110 having the form of the integrator compares the audio signal Vin with a signal fed back from the output signal Vo to generate the signal Vea corresponding to a difference between the audio signal Vin and the output signal Vo. The amplifier 120 compares the signal Vea with the triangular wave signal to generate the PWM signal, and an output of the amplifier 120 is PWM switched by the PWM signal. The PWM signal passes an inductor-capacitor (LC) LPF so as to reproduce the audio signal Vin. Here, the output signal Vo and the audio signal Vin have a gain due to feedback resistances as in Equation 1:

$$\frac{V_o}{V_{in}} = 1 + \frac{R_b}{R_a} \qquad \ldots (1)$$

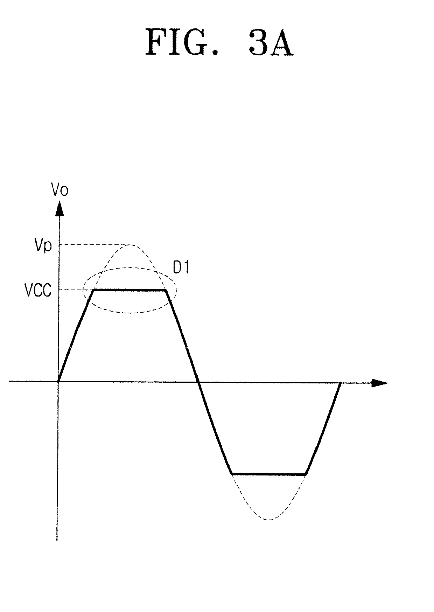

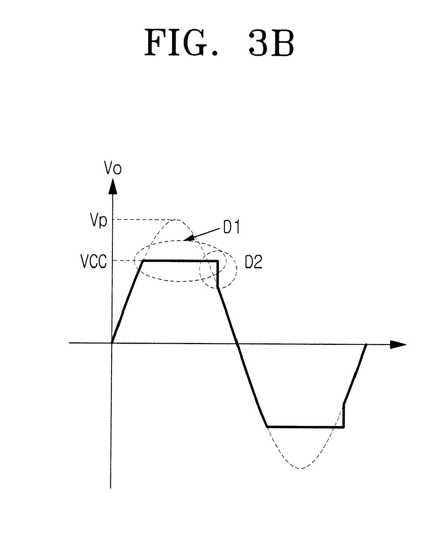

As shown in Equation 1, the output signal Vo increases with an increase in the audio signal Vin. If a peak vertex Vp of the output signal Vo exceeds a power supply voltage VCC due to a further increase in the audio signal Vin, the output signal Vo is clipped on an output level corresponding to the power voltage VCC as shown in Figure 3A or 3B. If the conventional D-class amplifier circuit is an analog amplifier circuit and not a digital amplifier circuit, the output signal Vo is simply clipped as shown in Figure 3A. Here, the output signal Vo has a distortion component defined as D1. However, if the conventional D-class amplifier circuit is a PWM switching amplifier which has been mainly used as a digital amplifier circuit, the output signal Vo has a waveform as shown in Figure 3B when being clipped. In such output signal Vo, there exists an additional stepped high frequency distortion component D2 at an edge of the clipped portion thereof besides the distortion component D1.

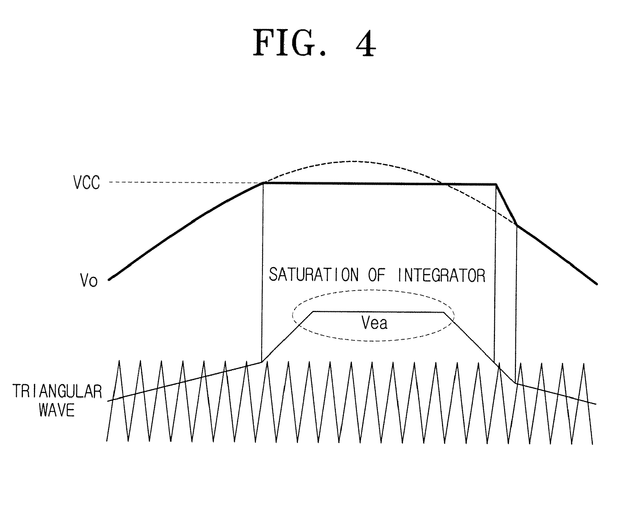

The generation of the additional stepped high frequency distortion component D2 shown in Figure 3B may be understood with reference to an internal operation waveform of a digital amplifier circuit shown in Figure 4. As shown in Figure 4, the signal Vea of the amplifier 110 gradually increases and is compared with the triangular wave signal until the output signal Vo is clipped. Thus, a duty ratio of the PWM signal gradually increases and reaches approximately 100%. It is to be noted that a point of time when the duty ratio reaches 100% is a point of time when the output signal Vo of the amplifier 110 increases up to the power supply voltage VCC. Thus, although the audio signal Vin is further amplified after this point of time, the output signal Vo does not exceeds the power supply voltage VCC and is clipped. Here, the signal Vea output from the amplifier 110 exceeds a range of the triangular wave signal and enters a saturation state. If the audio signal Vin is attenuated through the peak vertex Vp and a value of the audio signal Vin becomes smaller than a feedback value of the clipped output signal Vo, the signal Vea output from the amplifier 110 passes the saturation state and enters the range of the triangular wave signal. A time delay necessarily occurs due to a characteristic of the integrator. The signal Vea is delayed so as to pass the saturation state and enter the range of triangular wave signal. The output signal Vo is continuously clipped for the delay time due to the characteristic of the integrator, and the signal Vea output from the amplifier 110 enters the range of the triangular wave signal and then a normal PWM operation. Thereafter, the output signal Vo varies at a steep gradient to rapidly follow an output corresponding to the audio signal Vin. Thus, a stepped distortion occurs.

The signal Vea output from the amplifier 110 must be within the range of the triangular wave to improve the stepped high frequency distortion component D2 generated when the output signal Vea is clipped. To achieve this, an input limiter is used to limit the audio signal Vin to an appropriate level or less. The input limiter may generally have a structure as shown in Figure 2A or 2B. Such a structure is simply constituted, but a level to be limited is restricted to a zener voltage or a diode voltage. Thus, it is difficult to freely vary the level. As a result, it is difficult to accurately cope with variations in a gain of an amplifier or a power supply voltage. Also, upper and lower portions of an over-input are clipped during limiting. Thus, an output is distorted.

According to the present invention there is provided an apparatus and method as set forth in the appended claims. Preferred features of the invention will be apparent from the dependent claims, and the description which follows.

Some exemplary embodiments of the present invention overcome the above disadvantages and problems. Some exemplary embodiments of the present invention overcome other disadvantages and problems not described above.

The present invention provides an input-gain control apparatus and method of an audio amplifier for automatically attenuating a gain of an acoustic signal based on a pre-set limited level to minimize distortion of the acoustic signal caused by clipping of the acoustic signal, and thereby limit an over-input of the acoustic signal to input the acoustic signal within a dynamic range if the acoustic signal is not input within the dynamic range in an audio apparatus including an acoustic amplifier and a switching amplifier.

According to an aspect of the present invention, there is provided an input-gain control apparatus of an audio amplifier including: a voltage detector detecting whether a voltage of an output signal of the audio amplifier exceeds a difference voltage between a power supply voltage and a margin voltage; and an input limiter limiting a gain of an input signal according to the detection result of the voltage detector so that the voltage of the output signal does not exceed the difference voltage.

The voltage detector may include: a constant voltage unit determining the margin voltage which is constant to the power supply voltage; a voltage divider determining upper and lower levels of the difference voltage; and a first switching unit performing a switching operation if there is a voltage exceeding the upper and lower levels.

The constant voltage unit may be a zener diode. The voltage divider may include: first and second resistors R1 and R2 used to determine the upper level; and third and fourth resistors R3 and R4 used to determine the lower level.

The first switching unit may be a switching element. The switching element may include a negative-positive-negative (NPN) type transistor or a positive-negative-positive (PNP) type transistor.

The input limiter may include: a second switching unit performing a switching operation according to a switching signal; and an output impedance attenuating the gain of the input signal according to the switching operation. The output impedance may be a resistor.

A voltage $V_{UL}$ of the upper level may be calculated using Equation

$$``V_{UL} = (VCC - V_{DZ1}) \bullet \frac{R2}{R1 + R2}"$$, wherein $V_{DZ1}$ denotes a backward voltage of a first zener diode DZ1.

A voltage $V_{LL}$ of the lower level may be calculated using Equation $``V_{LL} = (VCC - V_{DZ2}) \bullet \frac{R4}{R3 + R4}"$,

wherein $V_{DZ2}$ denotes a backward voltage of a second zener diode DZ2.

A resistance ratio of the voltage divider may be "R1:R2=R3:R4."

According to another aspect of the present invention, there is provided an input-gain control method of an audio amplifier including: detecting whether a voltage of an output signal of the audio amplifier exceeds a difference voltage between a power supply voltage and a margin voltage; and limiting a gain of an input signal according to the detection result so that the voltage of the output signal does not exceed the difference voltage.

The detecting of whether the voltage of the output signal of the audio amplifier exceeds the difference voltage between the power supply voltage and the margin voltage may include: determining the margin voltage which is constant to the power supply voltage; determining upper and lower levels of the difference voltage; and performing a switching operation if there is a voltage exceeding the upper and lower levels.

The margin voltage may be determined using a constant voltage element.

The upper level may be determined using first and second resistors, and the lower level may be determined using third and fourth resistors.

A resistance ratio between the first and second resistors may be equal to a resistance ratio between the third and fourth resistors.

A voltage $V_{UL}$ of the upper level may be calculated using Equation $``V_{UL} = (VCC - V_{DZ1}) \bullet \frac{R2}{R1 + R2}"$,

wherein $V_{DZ1}$ denotes a backward voltage of a first zener diode DZ1.

A voltage VLL of the lower level may be calculated using Equation " $V_{LL} = (VCC - V_{DZ2}) \bullet \dfrac{R4}{R3 + R4}$ ",

wherein $V_{DZ2}$ denotes a backward voltage of a second zener diode DZ2.

The limiting of the gain of the input signal according to the detection result so that the voltage of the output signal does not exceed the difference voltage may include: performing a switching operation according to a switching signal; and attenuating the gain of the input signal according to the switching operation.

For a better understanding of the invention, and to show how embodiments of the same may be carried into effect, reference will now be made, by way of example, to the accompanying diagrammatic drawings in which:

Figure 1 is a schematic diagram illustrating a structure of a related art D-class amplifier circuit;

Figures 2A and 2B are circuit diagrams illustrating a related art limiter circuit;

Figures 3A and 3B are graphs illustrating clipping of an output voltage occurring when a peak vertex Vp of the output voltage exceeds a power supply voltage VCC;

Figure 4 is a graph illustrating an internal operation waveform of an audio amplifier circuit;

Figure 5 is a circuit diagram illustrating an input-gain control apparatus of an audio amplifier according to an exemplary embodiment of the present invention; and

Figure 6 is a graph illustrating a waveform of an output voltage output within a margin voltage according to an exemplary embodiment of the present invention.

Certain exemplary embodiments of the present invention will be described in greater detail with reference to the accompanying drawings. Throughout the drawings, the same drawing reference numerals will be understood to refer to the same elements, features, and structures.

The matters defined in the description such as a detailed construction and elements are nothing but the ones provided to assist in a comprehensive understanding of the invention. Accordingly, those of ordinary skill in the art will recognize that various changes and modifications of the exemplary embodiments described herein can be made without departing from the scope of the invention. Also, well-known functions or constructions are omitted from descriptions for clarity and conciseness.

An aspect of the present invention is to attenuate an over-input signal to prevent a clipping distortion D1 caused by an over-input, an over-output and a stepped high frequency distortion D2 caused by a saturation of an internal block of the audio amplifier, so that an output signal does not approach a power supply voltage VCC of the audio amplifier but is within a margin voltage dV regardless of variations in a gain and the power supply voltage VCC of the audio amplifier. Also, a whole gain may be attenuated instead of simply cutting over-input components to maintain an original form of an input signal and thereby minimize a distortion of the input signal to limit an input level. In addition, the margin voltage dV may be adjusted with respect to the power voltage VCC to vary an output limited level so as to design an amplifier having various output powers depending on products. Thus, the amplifier may be designed to have the same speaker impedance and power supply voltage as a previously designed amplifier so as to share a speaker and a power source block.

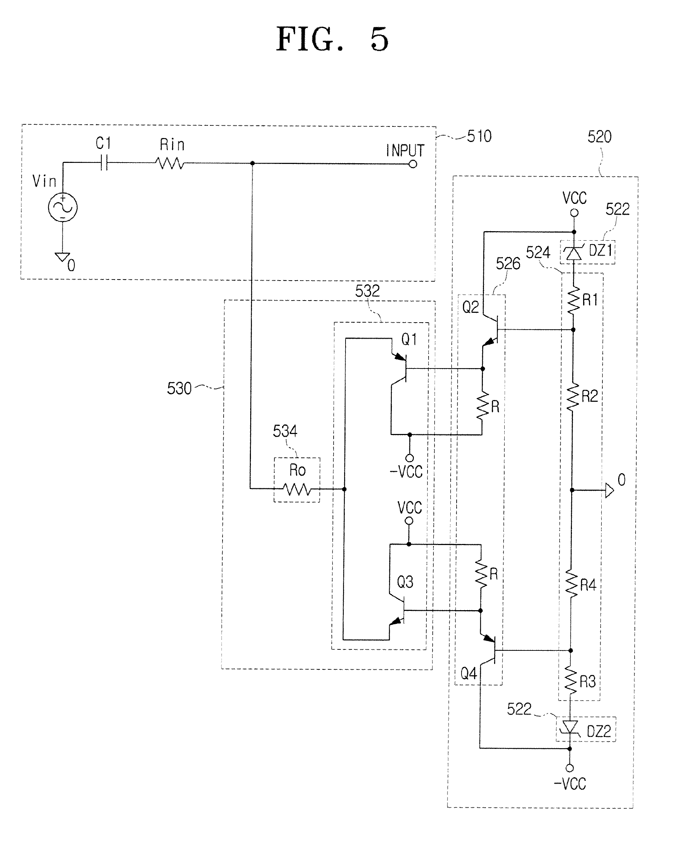

Figure 5 is a circuit diagram illustrating an input-gain control apparatus of an audio amplifier according to an exemplary embodiment of the present invention. Referring to Figure 5, the input-gain control apparatus of the audio amplifier according to the present exemplary embodiment includes an input unit 510, a voltage detector 520, and an input limiter 530.

The input-gain control apparatus further includes the comparator 120, the gate driver 130, the low pass filter (LPF) 140, and the triangular wave generator 150 as shown in Figure 1. The structures of the comparator 120, the gate driver 130, the LPF 140, and the triangular wave generator 150 have been described above, and thus their detailed descriptions will be omitted herein.

In the input unit 510, a capacitor C1 is connected to an input resistor Rin in series between an input port INPUT and an input power source Vin.

The voltage detector 520 detects whether a voltage of an output signal output from the audio amplifier exceeds a difference voltage between a power supply voltage VCC and a margin voltage dV.

The input limiter 530 limits the gain of an input signal according to the detection result of the voltage detector 520 so that the voltage of the output signal does not exceed the difference voltage.

Here, the voltage detector 520 includes a constant voltage unit 522, a voltage divider 524, and a first switching unit 526. The constant voltage unit 522 determines the margin voltage dV which is constant to the power supply voltage VCC. The voltage divider 524 determines upper and lower levels of the different voltage. The first switching unit 526 performs a switching operation according to a voltage exceeding the upper and lower levels.

Here, the constant voltage unit 522 includes first and second zener diodes DZ1 and DZ2, and the voltage divider 524 includes first, second, third, and fourth resistors R1, R2, R3, and R4. Also, the first switching unit 526 includes a negative-positive-negative (NPN) type (second) transistor Q2 and a positive-negative-positive (PNP) type (fourth) transistor Q4.

In other words, as shown in Figure 5, in the voltage detector 520, the first zener diode DZ1, the first resistor R1, the second resistor R2, the fourth resistor R4, the third resistor R3, and the second zener diode DZ2 are connected in series between a plus power supply voltage +VCC and a minus power supply voltage -VCC. Here, a base of the second transistor Q2 is connected to a connection point between the first and second resistors R1 and R2, and a collector of the second transistor Q2 is connected to a connection point between the plus power supply voltage +VCC and the first zener diode DZ1. An emitter of the second transistor Q2 is connected to the minus power supply voltage -VCC and the input limiter 530 through a resistor R.

Also, a base of the fourth transistor Q4 is connected to a connection point between the third and fourth resistors R3 and R4, and an emitter of the fourth transistor Q4 is connected to the plus power supply voltage +VCC through a resistor R. Also, a collector of the fourth transistor Q4 is connected to a connection point between the minus power supply voltage -VCC and the second zener diode DZ2.

The input limiter 530 includes a second switching unit 532 which performs a switching operation according to a switching signal and an output impedance 534 which attenuates the gain of the input signal according to the switching operation.

Here, the second switching unit 532 includes a PNP type (first) transistor Q1 and an NPN type (third) transistor Q3, and the output impedance 534 includes an output resistor Ro.

In other words, in the input limiter 530, a base of the first transistor Q1 is connected to the emitter of the second transistor Q2 of the voltage detector 520, a collector of the first transistor Q1 is connected to the minus power supply voltage -VCC, and an emitter of the first transistor Q1 is connected to the output resistor Ro. Also, a base of the third transistor Q3 is connected to the emitter of the fourth transistor Q4, a collector of the third transistor Q3 is connected to the plus power supply voltage +VCC, and an emitter of the third transistor Q3 is connected to the output resistor Ro. The output resistor Ro is connected in series between the input port INPUT and the input resistor Rin.

Here, the output resistor Ro may be a variable resistor element and vary a resistance value to adjust the attenuation of the gain.

A resistance ratio between the first and second resistors R1 and R2 is equal to a resistance ratio between the third and fourth resistors R3 and R4, and the margin voltage dV means a voltage disallowing the voltage of the output signal to approach the power supply voltage VCC.

The operation of the input-gain control apparatus of the audio amplifier according to the present exemplary embodiment will now be described.

For the description of the operation of the input-gain control apparatus, it is supposed that the input-gain control apparatus shown in Figure 5 is constituted as an input part of the audio amplifier shown in Figure 1.

Here, the input-gain control apparatus operates when the voltage of the output signal exceeds the margin voltage dV which is constant to the power supply voltage VCC. If the voltage of the output signal exceeds the difference voltage obtained through the subtraction of the margin voltage dV, i.e., a zener voltage of the first zener diode DZ1, from the power supply voltage VCC, the voltage falls due to the first and second resistors R1 and R2. Here, a current generated by the first resistor R1 is applied to the base of the second transistor Q2 to operate the second transistor Q2.

If the voltage of the output signal exceeds the difference voltage obtained through the subtraction of the margin voltage dV, i.e., a zener voltage of the second zener diode DZ2, from the power supply voltage -VCC, the voltage falls due to the third resistor R3. Here, the base of the fourth transistor Q4 is changed into a low level according to a current generated by the third resistor R3 to operate the fourth transistor Q4.

The first and third transistors Q1 and Q3 of the input limiter 530 operate with the operations of the second and fourth transistors Q2 and Q4 of the voltage detector 520.

Here, if turn-on voltages of the bases of the first, second, third, and fourth transistors Q1, Q2, Q3, and Q4 are equal to turn-on voltages of the emitters of the first, second, third, and fourth transistors Q1, Q2, Q3, and Q4, an upper level (upper level voltage $V_{UL}$) of an input limit is obtained as in Equation 2, and a lower level (lower level voltage $V_{LL}$) of an input limit is obtained as in Equation 3:

$$V_{UL} = (VCC - V_{DZ1}) \bullet \frac{R2}{R1 + R2} \qquad \ldots (2)$$

wherein $V_{DZ1}$ denotes a backward voltage of the first zener diode DZ1.

$$V_{LL} = (VCC - V_{DZ2}) \bullet \frac{R4}{R3 + R4} \qquad \ldots (3)$$

wherein $V_{DZ2}$ denotes a backward voltage of the second zener diode DZ2.

Voltages of the first and second zener diodes DZ1 and DZ2 are set to have the same value.

Currents generated by the operations of the first and third transistors Q1 and Q3 are applied to the output resistor Ro, and a level of the input signal is adjusted by the output resistor Ro to be within the margin voltage dV.

If a gain is obtained due to feedback resistances as in Equation 1 and a resistance ratio of a voltage divider is "R1:R2=R3:R4≡Ra:Rb," a voltage Vclip of an output signal on a clipping level can be obtained as in Equation 4:

$$V_{clip} = V_{UL} \bullet (1 + \frac{R_b}{R_a}) = VCC - V_{DZ1} \qquad \ldots (4)$$

Since the clipping level of the output signal is given as in Equation 4, a margin voltage dV is constant to a power supply voltage VCC regardless of variations in the power supply voltage VCC. In other words, the margin voltage dV is obtained through a subtraction of a zener diode voltage VDZ1 from the power supply voltage VCC and thus determined by a voltage of a zener diode.

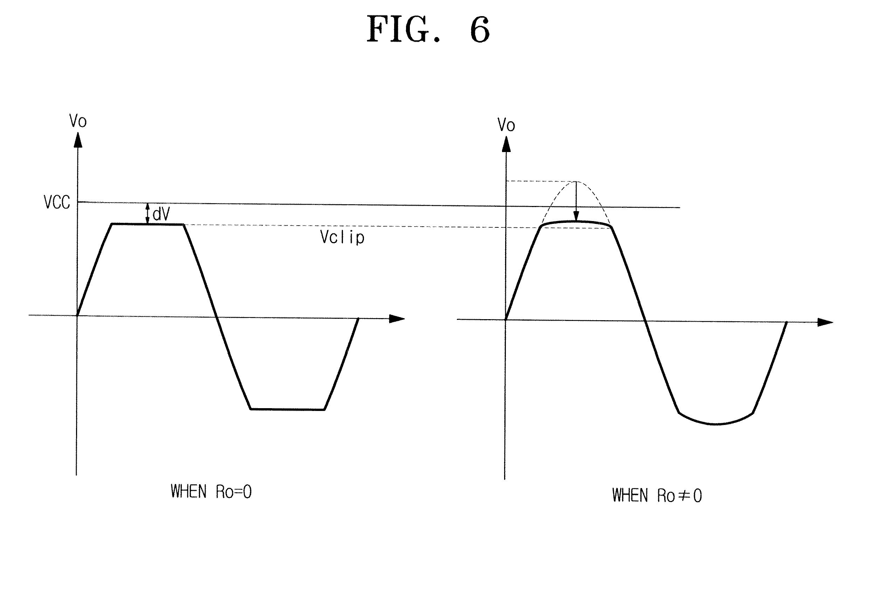

Also, if an output impedance Ro is adjusted to an appropriate value, components exceeding a limit level may be simply removed. Also, as shown in the figure on the right side of Figure 6, when the output impedance Ro is not zero, an appropriate amount may be added on clipped level. Thus, a distortion component D1 caused by simple clipping may be considerably relieved.

As described above, in input-gain control apparatus and method of an audio amplifier according to exemplary embodiments of the present invention, a gain of the acoustic signal may be automatically attenuated based on a preset limit level to input the acoustic signal within the dynamic range in an audio apparatus including an acoustic amplifier and a switching amplifier, if an acoustic signal exceeds a dynamic range. Thus, the distortion of the acoustic signal caused by clipping of the acoustic signal may be minimized, and an over-input may be limited.

As described above, in input-gain control apparatus and method of an audio amplifier according to exemplary embodiments of the present invention, only a gain of an over-input signal on a specific level or more can be attenuated instead of simply cutting the over-input signal. Thus, a distortion of an output waveform caused by clipping of the output waveform can be minimized. In particular, a switching amplifier can prevent a saturation of an internal block to simultaneously remove a harmonic distortion and a stepped high frequency noise which occurs during clipping. Also, a linear analog amplifier can attenuate only the gain while maintaining an original form of the over-input signal instead of simply clipping the over-input signal so as to minimize a distortion of an output signal.

Electronic appliances having an audio function can use an identical power supply voltage to arbitrarily adjust a reference voltage of an output comparator circuit operating as a gain attenuating circuit to limit an output level. Thus, an effect shown when a power source or a speaker impedance is varied can be obtained without varying the power source or the speaker impedance. Accordingly, a power supply voltage and a speaker impedance of a product having various output specifications can be standardized.

The described embodiments of the present invention are merely exemplary and are not to be construed as limiting the present invention. The present exemplary teachings can be readily applied to other types of apparatuses. Also, the description of the exemplary embodiments of the present invention is intended to be illustrative, and not to limit the scope of the claims, and many alternatives, modifications, and variations will be apparent to those skilled in the art without departing from the spirit and scope of the invention as defined by the appended claims and the full scope of equivalents thereof.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

**Claims**

1. An input-gain control apparatus of an audio amplifier, the input-gain control apparatus comprising:

   a voltage detector (520) which detects whether a voltage of an output signal of the audio amplifier exceeds a difference voltage which is a voltage difference between a power supply voltage and a margin voltage; and
   an input limiter (530) which limits a gain of an input signal according to a detection result of the voltage detector (520) to prevent the voltage of the output signal from exceeding the difference voltage.

2. The input-gain control apparatus of claim 1, wherein the voltage detector (520) comprises:

   a constant voltage unit (522) which determines the margin voltage which is constant to the power supply voltage;
   a voltage divider (524) which determines upper and lower levels of the difference voltage; and
   a first switching unit (526) which performs a switching operation if the voltage of the output signal exceeds the upper level of the difference voltage and falls below the lower level of the difference voltage.

3. The input-gain control apparatus of claim 2, wherein the constant voltage unit (522) comprises a zener diode.

4. The input-gain control apparatus of claim 2 or 3, wherein the voltage divider (524) comprises:

   first and second resistors (R1,R2) which determines the upper level of the difference voltage; and
   third and fourth resistors (R3,R4) which determines the lower level of the difference voltage.

5. The input-gain control apparatus of claim 2, 3 or 4, wherein the first switching unit (526) is a switching element.

6. The input-gain control apparatus of claim 5, wherein the switching element comprises one of an negative-positive-negative (NPN) type transistor and a positive-negative-positive (PNP) type transistor.

7. The input-gain control apparatus of any of claims 1 to 6, wherein the input limiter (530) comprises:

   a second switching unit (532) which performs a switching operation according to a switching signal; and
   an output impedance (534) which attenuates the gain of the input signal according to the switching operation.

8. The input-gain control apparatus of claim 7, wherein the output impedance (534) is a resistor.

9. The input-gain control apparatus of claim 7, wherein the output impedance (534) is a variable resistor.

10. The input-gain control apparatus of any of claims 4 to 9, wherein a resistance ratio of the voltage divider (524) is R1:R2=R3:R4.

11. An input-gain control method of an audio amplifier comprising:

   detecting whether a voltage of an output signal of the audio amplifier exceeds a difference voltage which is a voltage difference between a power supply voltage and a margin voltage; and
limiting a gain of an input signal according to a result of the detecting to prevent the voltage of the output signal from exceeding the difference voltage.

**12.** The input-gain control method of claim 11, wherein the detecting whether the voltage of the output signal of the audio amplifier exceeds the difference voltage comprises:

determining the margin voltage which is constant to the power supply voltage;
determining upper and lower levels of the difference voltage; and
performing a switching operation if the voltage of the output signal exceeds the upper level of the difference voltage and falls below the lower level of the difference voltage.

**13.** The input-gain control apparatus of claim 11 or 12, wherein the margin voltage is determined using a constant voltage element.

**14.** The input-gain control method of claim 12 or 13, wherein the upper level of the difference voltage is determined using first and second resistors, and the lower level of the difference voltage is determined using third and fourth resistors.

**15.** The input-gain control method of claim 14, wherein a resistance ratio between the first and second resistors is equal to a resistance ratio between the third and fourth resistors.

**16.** The input-gain control method of any of claims 11 to 15, wherein the limiting of the gain of the input signal according to the result of the detecting comprises:

performing a switching operation according to a switching signal; and
attenuating the gain of the input signal according to the switching operation.

# FIG. 1

EP 1 865 598 A2

# FIG. 2A

# FIG. 2B

# FIG. 3A

# FIG. 3B

# FIG. 4

# FIG. 5

# FIG. 6

WHEN Ro=0

WHEN Ro≠0

EP 1 865 598 A2